# EUROPÄISCHE PATENTSCHRIFT

(11) **EP 3 343 636 B1**
(45) Veröffentlichungstag und Bekanntmachung des Hinweises auf die Patenterteilung: **08.07.2020**
(21) Anmeldenummer: 17002087.9
(22) Anmeldetag: 27.12.2017
(51) Int. Cl.: H01L 29/739, H01L 29/36, H01L 29/20, H01L 21/22

(54) **IGBT HALBLEITERSTRUKTUR**
IGBT SEMICONDUCTOR STRUCTURE
STRUCTURE SEMI-CONDUCTRICE IGBT

(30) Priorität: 28.12.2016 DE 102016015475
(43) Veröffentlichungstag der Anmeldung: 04.07.2018
(73) Patentinhaber: 3-5 Power Electronics GmbH, 01217 Dresden (DE)
(72) Erfinder: Dudek, Volker, 76275 Ettlingen (DE)
(74) Vertreter: Koch Müller Patentanwaltsgesellschaft mbH

(56) Entgegenhaltungen:
- EP-A1- 0 780 905
- EP-A2- 0 603 737
- DE-A1-102015 208 097
- JP-A- 2001 077 357
- US-A1- 2014 217 407
- M. HOSSIN ET AL: "Evaluation of GaAs Schottky gate bipolar transistor (SGBT) by electrothermal simulation", SOLID STATE ELECTRONICS., Bd. 44, Nr. 1, 1. Januar 2000 (2000-01-01) , Seiten 85-94, XP055468980, GB ISSN: 0038-1101, DOI: 10.1016/S0038-1101(99)00211-7

## Beschreibung

Die Erfindung betrifft IGBT Halbleiterstruktur mit einem p⁺-Substrat, einer n⁻-Schicht, einem p-Bereich, einem n⁺-Bereich, einer dielektrischen Schicht sowie drei Anschlusskontakten.

IGBT-Strukturen auf Si-Basis sind aus der JP 2001 077357 A und der DE 10 2015 208097 bekannt. Leistungstransistoren auf GaAs-Basis sind aus "Evalutation of GaAs Schottky gate bipolar transistor (SGBT) by electrothermal simulation", Hossin et al., Solid-State Electronics, Bd. 44, Nr. 1, S. 85-94, 1. Januar 2000 und der EP 0 603 737 A2 bekannt.

Aus Josef Lutz et al., "Semiconductor Power Devices", Springer Verlag, 2011, ISBN 978-3-642-11124-2, Kapitel 10, S. 322, 323 und 330 sind IGBTs in verschiedenen Ausführungsformen bekannt. Derartige Leistungsbauelemente werden auf Basis von Silizium oder SIC hergestellt.

Eine hochspannungsfeste Halbleiterdiode p⁺ - n - n⁺ sowie ein hochspannungsfester p-n-i-p Transistor auf Basis von GaAs ist aus "GaAs Power Devices" von German Ashkinazi, ISBN 965-7094-19-4, Kapitel 5, S. 97 bzw. Kapitel 7.8, S. 225 bekannt.

Ein Abscheiden von Oxidschichten auf GaAs beispielsweise mittels eines Atomic Layer Deposition (ALD) Prozesses wird in den Artikeln "New Insight into Fermi-Level Unpinning on GaAs: Impact of Different Surface Orientations", M. Xu et al., Electron Device Meeting (IEDM), IEEE, 2009, pp. 865-868, und in "Impact of Buffer Layer on Atomic Layer Deposited TiAlO Alloy Dielectric Quality for Epitaxial-GaAs/Ge Device Application", G. K. Dalapati et al., IEEE Transactions on Electron Devices, Vol. 60, No. 1, 2013 beschrieben.

Vor diesem Hintergrund besteht die Aufgabe der Erfindung darin, eine Vorrichtung anzugeben, die den Stand der Technik weiterbildet.

Die Aufgabe wird durch eine IGBT Halbleiterstruktur mit den Merkmalen des Patentanspruchs 1 gelöst. Vorteilhafte Ausgestaltungen der Erfindung sind Gegenstand von Unteransprüchen.

Gemäß dem Gegenstand der Erfindung wird eine IGBT Halbleiterstruktur mit einer Oberseite und einer Unterseite bereitgestellt.

Die IGBT Halbleiterstruktur weist ein an der Unterseite der IGBT Halbleiterstruktur ausgebildetes p⁺-Substrat und eine auf dem p⁺-Substrat aufliegende n⁻-Schicht auf.

Die n⁻-Schicht weist einen angrenzenden p-Bereich und mindestens einen an den p-Bereich angrenzenden n⁺-Bereich auf.

Eine vorzugsweise aus einem abgeschiedenen Oxid bestehende dielektrische Schicht, einen mit der Unterseite der IGBT Halbleiterstruktur elektrisch leitend verbundenen ersten Anschlusskontakt, einen zweiten Anschlusskontakt und einen dritten Anschlusskontakt.

Das p⁺-Substrat weist eine Dotierstoffkonzentration von 5^{∗}10¹⁸-5^{∗}10²⁰cm⁻³ und eine Schichtdicke von 50-500 µm auf.

Die n⁻-Schicht weist eine Dotierstoffkonzentration von 10¹²-10¹⁷ cm⁻³ und eine Schichtdicke von 10-300 µm) auf.

Der mindestens einen p-Bereich weist eine Dotierstoffkonzentration von 10¹⁴-10¹⁸ cm⁻³ und der mindestens eine n⁺-Bereich eine Dotierstoffkonzentration von mindestens 10¹⁹cm⁻³ auf, wobei der mindestens eine p-Bereich mit der n⁻-Schicht einen ersten pn-Übergang ausbildet.

Der eine n⁺-Bereich bildet mit dem einen p-Bereich einen zweiten pn-Übergang aus.

Das p⁺-Substrat, die n⁻-Schicht, der p-Bereich sowie der n⁺-Bereich umfassen jeweils eine GaAs-Verbindung oder bestehen jeweils aus einer GaAs Verbindung.

Der erste Anschlusskontakt, der zweite Anschlusskontakt und der dritte Anschlusskontakt umfassen jeweils ein Metall oder eine Metallverbindung oder bestehen jeweils aus einem Metall oder einer Metallverbindung, wobei der zweite Anschlusskontakt als Feldplatte auf der dielektrischen Schicht ausgebildet ist.

Der dritte Anschlusskontakt ist mit dem mindestens einen p-Bereich und dem mindestens einen n⁺-Bereich elektrisch leitend verbunden.

Vorzugsweise sind die Anschlusskontakte jeweils an der Oberfläche der Halbleiterstruktur angeordnet.

Die dielektrische Schicht überdeckt zumindest den ersten pn-Übergang und den zweiten pn-Übergang und Ist mit der n⁻-Schicht, dem p-Bereich und dem n⁺-Bereich stoffschlüssig verbunden.

Zusätzlich ist zwischen dem p⁺-Substrat und der n⁻-Schicht eine dotierte Zwischenschicht mit einer Schichtdicke von 1 µm -50 µm und einer Dotierstoffkonzentration von 10¹²-10¹⁷ cm⁻³ angeordnet, wobei die Zwischenschicht zumindest mit dem p⁺-Substrat stoffschlüssig verbunden ist.

Es sei angemerkt, dass der zweite Anschlusskontakt als Gate bezeichnet wird. Der erste Anschlusskontakt wird typischerweise als Kollektor oder Anode bezeichnet, während der dritte Anschlusskontakt als Emitter oder Kathode bezeichnet wird.

Es versteht sich, dass auf die Anschlusskontakte als Schichten ausgebildet sind. Die Anschlusskontakte sind jeweils elektrisch leitfähig und weisen metallische Eigenschaften auf. Aus dem Stand der Technik bekannt sind auch Anschlusskontakte umfassend oder bestehend aus metallisch leitfähigen Halbleiterschichten oder Metallschichten oder eine Kombination aus beiden. Die Anschlusskontakte stellen einen elektrisch niederohmigen Kontakt zu den unmittelbar angrenzenden dotierten Halbleiterschichten her.

Des Weiteren versteht es sich, dass die Anschlusskontakte vorzugsweise mittels Bonddrähte mit Kontaktfinger, den sogenannten Pins, verschaltet sind.

Es versteht sich ferner, dass die Zwischenschicht eine im Vergleich zu den angrenzenden Schichten wenigstens eine unterschiedliche Dotierstoffkonzentration aufweist.

Ein Vorteil ist, dass sich GaAs Halbleiterstrukturen im Vergleich zu Silizium die Ladungsträger eine kleinere effektive Masse aufweisen. Auch lassen sich im Vergleich zu Si höheren Temperaturen an den pn-Übergängen erreichen, ohne dass die Bauelemente zerstört werden. Hierdurch lassen sich mit den GaAs Halbleiterstrukturen höhere Schaltfrequenzen und geringere Verluste als mit den vergleichbaren SI-Hableiterstrukturen erzielen.

Ein weiterer Vorteil ist, dass sich die III-V IGBT Halbleiterstruktur kostengünstiger als vergleichbare Halbleiterstrukturen aus SiC herstellen lassen.

Ein anderer Vorteil der erfindungsgemäßen III-V-IGBT-Halbleiterstruktur ist eine hohe Temperaturfestigkeit von bis zu 300°C. Anders ausgedrückt lassen sich die III-V-Halbleiterdioden auch in heißen Umgebungen einsetzten.

In einer ersten Ausführungsform ist die Zwischenschicht p-dotiert ausgebildet und umfasst gemäß alternativer Weiterbildungen als Dotierstoffe Zink und / oder Silizium. Die Dotierstoffkonzentration der Zwischenschicht ist bevorzugt kleiner als die Dotierstoffkonzentration des p⁺-Substrats. Besonders bevorzugt ist die Dotierstoffkonzentration in einem Bereich zwischen einem Faktor 2 bis zu einem Faktor von fünf Größenordnungen kleiner.

In einer anderen Ausführungsform ist die Zwischenschicht n-dotiert ausgebildet und umfasst als Dotierstoff vorzugsweise Silizium und/oder Zinn. Die Dotierstoffkonzentration der Zwischenschicht ist bevorzugt kleiner als die Dotierstoffkonzentration des n⁺-Substrats. Besonders bevorzugt ist die Dotierstoffkonzentration bis zu einem Faktor 100 kleiner als die Dotierstoffkonzentration der n⁻-Schicht.

Gemäß einer weiteren Ausführungsform weist die IGBT Halbleiterstruktur eine n-dotierte Pufferschicht auf, wobei die Pufferschicht zwischen der Zwischenschicht und der n⁻-Schicht angeordnet ist, eine Dotierstoffkonzentration von 10¹²-10¹⁶ cm⁻³ und eine Schichtdicke von 1 µm -50 µm aufweist und eine GaAs-Verbindung umfasst oder aus einer GaAs Verbindung besteht.

In einer anderen Ausführungsform ist die IGBT Halbleiterstruktur als Trench IGBT Halbleiterstruktur ausgebildet, wobei die dielektrische Schicht senkrecht zu der Oberseite der IGBT Halbleiterstruktur verläuft.

Das p⁺-Substrat umfasst bevorzugt Zink. Die n⁻-Schicht und/oder der n⁺-Bereich umfassen bevorzugt Silizium und/oder Chrom und/oder Palladium und/oder Zinn, wobei die IGBZ Halbleiterstruktur besonders bevorzugt monolithisch ausgebildet ist.

Gemäß einer weiteren Ausführungsform beträgt eine Gesamthöhe der IGBT Halbleiterstruktur höchstens 150-500 µm und /oder eine Kantenlänge oder ein Durchmesser der IGBT Halbleitstruktur betragen zwischen 1 mm und 15 mm.

In einer anderen Ausführungsform sind der p-Bereich und/oder der n-Bereich an der Oberseite der IGBT Halbleiterstruktur kreisförmig oder gerade mit jeweils an der Stirnseite der Strukturen angeordneten Halbkreisen ausgebildet.

Gemäß einer Weiterbildung umfasst die dielektrische Schicht ein abgeschiedenes Oxid und weist eine Schichtdicke von 10nm bis 1µm auf.

In einem Beispiel, das das Verständnis der Erfindung erleichtert, weist der stapelförmige Schichtaufbau ein zwischen der n⁻-Schicht und dem p⁺-Substrat ausgebildeter Halbleiterbond auf.

Es wird angemerkt, dass der Ausdruck Halbleiterbond synonym mit dem Ausdruck Waferbond verwendet wird.

In einem Beispiel bildet der Schichtaufbau bestehend aus einem p⁺-Substrat bildet einen ersten Teilstapel und der Schichtaufbau bestehend aus der n⁺-Schicht eine der n⁻-Schicht und gegebenenfalls der Pufferschicht einen zweiten Teilstapel.

In einem weiteren Beispiel umfasst der stapelförmige Schichtaufbau eine zwischen dem p⁺-Substrat und der n⁻-Schicht angeordnete Zwischenschicht auf. Hierbei umfasst der erste Teilstapel die Zwischenschicht. Der Halbleiterbond ist zwischen der Zwischenschicht und der n⁻-Schicht oder zwischen der Zwischenschicht und der Pufferschicht angeordnet.

In einem weiteren Beispiel sind der erste Teilstapel und der zweite Teilstapel jeweils monolithisch ausgebildet.

In einem weiteren Beispiel wird der erste Teilstapel gebildet, in dem ausgehend von einem p⁺-Substrat mittels Epitaxie die Zwischenschicht hergestellt wird. Vorzugsweise weist die als p⁻-Schicht ausgebildete Zwischenschicht eine Dotierung kleiner als 10¹³ N/cm⁻³, d.h. die Zwischenschicht ist intrinsisch dotiert, oder eine Dotierung zwischen 10¹³ N/cm⁻³ und 10¹⁵ N/cm⁻³ auf. In einer Ausführungsform wird das p⁺-Substrat vor oder nach dem Bonden durch einen Schleifprozess auf eine Dicke zwischen 200 µm und 500 µm gedünnt.

In einem weiteren Beispiel wird der zweite Stapel gebildet, in dem ausgehend von einem n⁻-Substrat, das n⁻-Substrat mit dem zweiten Stapel, d.h. mit der n⁺-Schicht durch einen Waferbondprozess verbunden wird. In einer Ausführungsform ist die n⁺-Schicht als n⁺-Substrat ausgebildet.

In einem weiteren Prozessschritt wird das n⁻-Substrat auf die gewünschte Dicke gedünnt.

In einem weiteren Beispiel wird nach dem dünnen des n⁻-Substrat bzw. der n⁻-Schicht mittels eine Epitaxieprozesses die Pufferschicht erzeugt.

Vorzugsweise liegt die Dicke des n⁻-Substrats bzw. der n⁻-Schicht in einem Bereich zwischen 50 µm bis 250 µm. Vorzugsweise liegt die Dotierung des n⁻-Substrats in einem Bereich zwischen 10¹³ N/cm⁻³ und 10¹⁵ N/cm⁻³. Ein Vorteil des Waferbondens ist es, dass sich dicke n⁻-Schichten ohne weiteres herstellen lassen. Ein langer Abscheideprozess bei der Epitaxie entfällt hierdurch. Auch lassen sich mittels des Waferbondens die Anzahl der Stapelfehler verringern.

In einem weiteren Beispiel weist das n⁻-Substrat eine Dotierung größer als 10¹⁰ N/cm⁻³ und kleiner als 10¹³ N/cm⁻³ auf. In dem die Dotierung extrem gering ist, lässt sich das n⁻-Substrat auch als eine intrinsische Schicht auffassen.

In einem weiteren Beispiel wird das n⁻-Substrat oder die Oberfläche der Pufferschicht unmittelbar auf den ersten Stapel mittels eines Halbleiterbondprozessschrittes verbunden. Anschließend wird die Rückseite des n⁻-Substrats auf die gewünschte Dicke der n⁻-Schicht gedünnt. Nach dem Dünnen des n⁻-Substrats bzw. der n⁻-Schicht wird mittels Epitaxie oder einer Hochdosisimplantation die n⁺-Schicht mit einer Dotierung in einem Bereich zwischen 10¹⁸ N/cm⁻³ und kleiner als 5x10¹⁹ N/cm⁻³ erzeugt.

Es versteht sich, dass das Dünnen des n⁻-Substrats vorzugsweise mittels eines CMP Schrittes, d.h. mittels chemischen mechanischen Polierens erfolgt.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände sowie die lateralen und die vertikalen Erstreckungen sind nicht maßstäblich und weisen, sofern nicht anders angegeben, auch keine ableitbaren geometrischen Relationen zueinander auf. Darin zeigen, die:
- Figur 1: eine schematische Ansicht einer erste erfindungsgemäßen Ausführungsform eines IGBTs,
- Figur 2: eine schematische Aufsicht auf die erste erfindungsgemäße Ausführungsform eines IGBTs
- Figur 3: eine schematische Ansicht einer zweiten erfindungsgemäßen Ausführungsform eines IGBTs,
- Figur 4: eine schematische Ansicht einer dritten erfindungsgemäßen Ausführungsform eines IGBTs,
- Figur 5: eine schematische Aufsicht auf die dritte erfindungsgemäße Ausführungsform eines IGBTs,
- Figur 6: eine schematische Ansicht einer vierten erfindungsgemäßen Ausführungsform eines IGBTs.

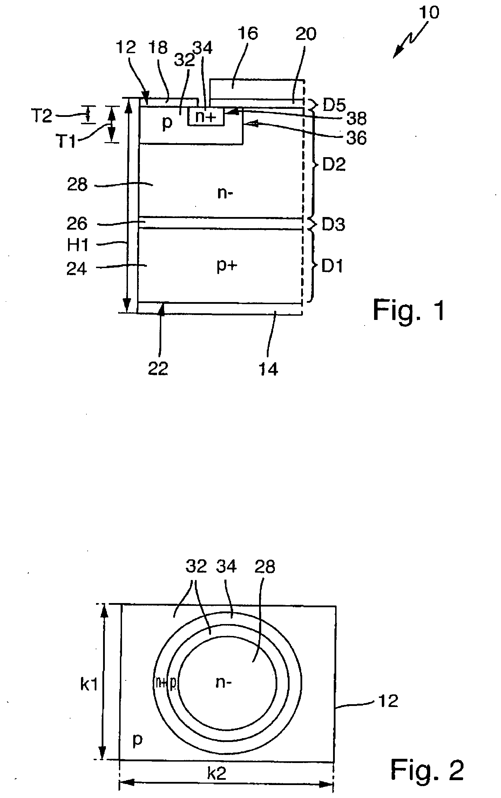

Die Abbildung der Figur 1 zeigt eine Schnittansicht einer ersten Ausführungsform einer IGBT Halbleiterstruktur 10 mit drei Anschlusskontakten 14, 16, 18 sowie einer dielektrischen Schicht 20. Die IGBT Halbleiterstruktur 10, im Folgenden auch als Halbleiterstruktur 10 bezeichnet, ist stapelförmig mit einer Oberseite 12 und einer Unterseite 22 ausgebildet und weist im dargestellten Ausführungsbeispiel ein sogenanntes non-punch-through Design und eine Gesamthöhe H1 auf.

Der erste Anschlusskontakt 14 ist als eine Metallschicht ausgebildet, wobei die Metallschicht stoffschlüssig mit der Unterseite 22 der Halbleiterstruktur 10 verbunden ist.

Unterste Schicht der IGBT Halbleiterstruktur bildet ein p⁺-Substrat 24. Das p⁺-Substrat bildet somit die Unterseite 22 der Halbleiterstruktur 10 aus und weist eine Schichtdicke D1 auf. Auf das p⁺-Substrat folgen eine dünne, schwach n- oder schwach p-dotlerte Zwischenschicht 26 mit einer Schichtdicke D3 und eine n⁻-Schicht 28 mit einer Schichtdicke D2 in der genannten Reihenfolge.

Im dargestellten Ausführungsbeispiel bildet die n⁻-Schicht 28 zumindest einen Teil der Oberseite 12 der Halbleiterstruktur 10 aus. Ein weiterer Teil der Oberseite 12 der Halbleiterstruktur 10 wird von einem p-Bereich 32 gebildet, wobei sich der p-Bereich 32 von der Oberseite 12 der IGBT Halbleiterstruktur 10 bis zu einer Tiefe T1 in die n⁻-Schicht hinein erstreckt.

Ein weiterer Teil der Oberseite 12 der Halbleiterstruktur 10 wird von einem n⁺-Bereich 34 gebildet, wobei sich der n⁺-Bereich von der Oberseite 12 der Halbleiterstruktur 10 bis zu einer Tiefe T2 in den p-Bereich hinein erstreckt und T2 kleiner T1 ist.

So bilden sich an die Oberseite 12 der Halbleiterstruktur 10 angrenzend ein erster pn-Übergang 36 zwischen dem p-Bereich und der n⁻-Schicht und ein zweiter pn-Übergang 38 zwischen dem n⁺-Bereich und dem p-Bereich aus, wobei die dielektrische Schicht 20 zumindest den ersten pn-Übergang 36 und den zweiten pn-Übergang 38 überdeckt und mit der Oberseite 12 der Halbleiterstruktur 10, insbesondere mit dem n⁺-Bereich, dem p-Bereich und der n⁻-Schicht stoffschlüssig verbunden ist und eine Schichtdicke D5 aufweist.

Der zweite Anschlusskontakt 16 ist als Feldplatte auf einer von der Halbleiterstruktur 10 abgewandten Oberfläche der dielektrischen Schicht 20 ausgebildet.

Der dritte Anschlusskontakt 18 ist ebenfalls als Metallschicht ausgebildet, wobei die Metallschicht stoffschlüssig mit einem von dem p-Bereich und von dem n⁺-Bereich gebildeten Teil der Oberseite 12 der Halbleiterstruktur 10 verbunden ist.

Der n⁺-Bereich 34, der p-Bereich 32 und die n⁻-Schicht 28 bilden zusammen mit der dielektrischen Schicht 16 und den drei Anschlusskontakten 14, 16, 18 einen MOS-Transistor also ein bipolares Bauteil aus, während p-Substrat 24, Zwischenschicht 26 und n⁻-Schicht 28 eine pin-Diode darstellen.

In der Abbildung der Figur 2 ist eine Aufsicht auf die Oberseite 12 der IGBT Halbleiterstruktur 10 dargestellt. Sowohl der p-Bereich 32 als auch der n⁺-Bereich 34 sind kreisförmig ausgebildet. Die IGBT Halbleiterstruktur 10 weist eine rechteckige Oberseite 12 mit einer ersten Katenlänge K1 und einer zweiten Kantenlänge K2 auf.

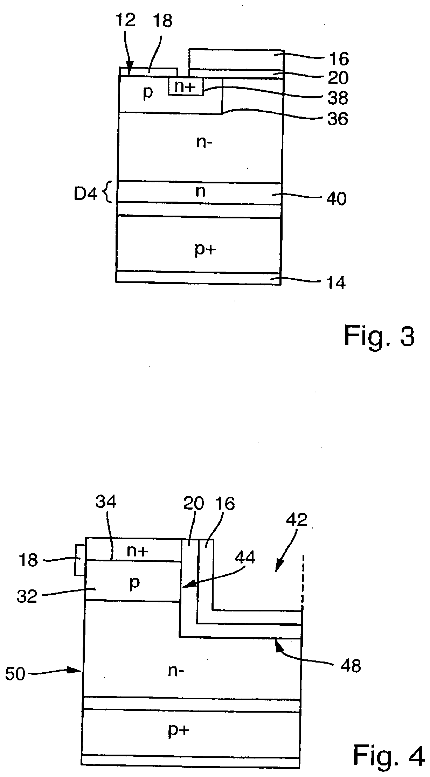

In der Abbildung der Figur 3 ist eine weitere Ausführungsform der IGBT Halbleiterstruktur 10 dargestellt. Im Folgenden werden nur die Unterschiede zu der Abbildung der Figur 1 erläutert. Die Halbleiterstruktur 10 ist als sogenannter punch-through IGBT ausgebildet, wobei zwischen der Zwischenschicht 26 und der n-Schicht 28 eine schwach n- oder p-dotierte Pufferschicht 40 mit einer Schichtdicke D4 angeordnet ist.

In der Abbildung der Figur 4 ist eine weitere Ausführungsform einer IGBT Halbleiterstruktur 10 dargestellt. Im Folgenden werden nur die Unterschiede zu den Abbildungen der Figuren 1 und 3 erläutert. Die Halbleiterstruktur 10 ist als sogenannter Trench-IGBT ausgebildet.

Der p-Bereich 32 und der n⁺-Bereich 34 sind jeweils als Schichten auf der n⁻Schicht bzw. dem p-Bereich 32 ausgebildet, wobei die Halbleiterstruktur 10 einen von der Oberseite 12 durch den schichtförmigen n-Bereich und den schichtförmigen p-Bereich bis in die n⁻-Schicht hinein reichenden Graben 42, den sogenannten Trench, aufweist.

Der erste pn-Übergang 36 und der zweite pn-Übergang 38 verlaufen senkrecht zu einer Seitenflächen 44 des Grabens 42. Die Seitenfläche 44 sowie ein Boden 46 des Grabens sind mit der dielektrischen Schicht 20 bedeckt. Der als Feldplatte ausgebildete zweite Anschlusskontakt 16 erstreckt entsprechend auf der dielektrischen Schicht 20. Der dritte Anschlusskontakt 18 ist an einer der Seitenfläche 44 des Grabens 42 gegenüberliegenden Seitenfläche 50 der Halbleiterstruktur 10 angeordnet und mit dem schichtförmigen n⁺-Bereich 34 sowie mit dem schichtförmigen p-Bereich 32 elektrisch leitfähig verbunden.

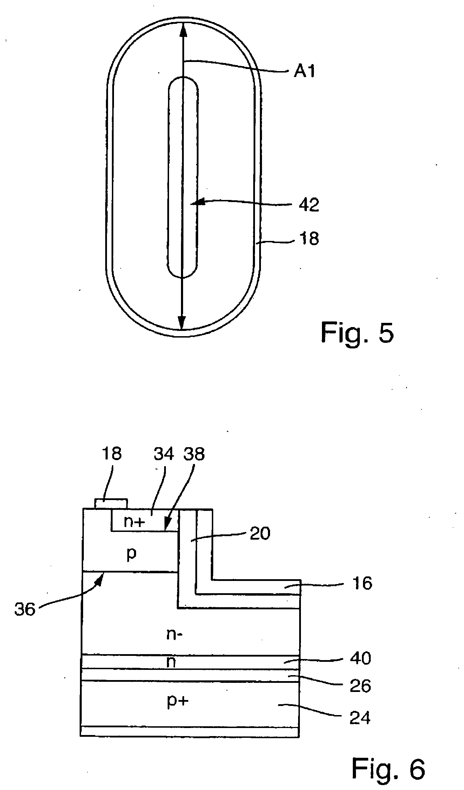

In einer alternativen Ausführungsform, dargestellt in der Figur 6 ist der dritte Anschlusskontakt 18 an der Oberseite 12 angeordnet. Anders ausgedrückt, der zweite pn-Übergang 38 ist auch an der Oberfläche, entsprechend der Ausführungsform, dargestellt in der Figur 1, ausgebildet.

Eine schematische Aufsicht auf den Trench IGBT gemäß Figur 4 ist in Figur 5 dargestellt. Der Graben 42 weist eine länglich, kreisrunde Form auf und die IGBT Halbleiterstruktur 10 einen Durchmesser A1.

In der Abbildung der Figur 6 ist eine weitere Ausführungsform der IGBT Halbleiterstruktur 10 dargestellt. Im Folgenden werden nur die Unterschiede zu der Abbildung der Figur 4 erläutert. Die ebenfalls als Trench IGBT ausgebildete Halbleiterstruktur 10 weist eine Pufferschicht 40 zwischen der Zwischenschicht 26 und der n⁻-Schicht 28 auf.

## Patentansprüche

1. IGBT Halbleiterstruktur (10) mit Oberseite (12) und Unterseite (22) aufweisend
- ein an der Unterseite (22) der IGBT Halbleiterstruktur (10) ausgebildetes p⁺-Substrat (24) mit einer Dotierstoffkonzentration von 5^{∗}10¹⁸-5^{∗}10²⁰cm⁻³, einer Schichtdicke (D1) von 50-500 µm und umfassend eine GaAs-Verbindung oder bestehend aus einer GaAs Verbindung,
- eine n⁻-Schicht (28) mit einer Dotierstoffkonzentration von 10¹²-10¹⁷ cm⁻³, einer Schichtdicke (D2) von 10-300 µm und eine GaAs-Verbindung umfassend oder aus einer GaAs Verbindung bestehend,
- mindestens einen an die n⁻-Schicht (28) angrenzenden p-Bereich (32) mit einer Dotierstoffkonzentration von 10¹⁴-10¹⁸ cm⁻³ und eine GaAs-Verbindung umfassend oder aus einer GaAs Verbindung bestehend ,
- mindestens einen an den p-Bereich (32) angrenzenden n⁺-Bereich (34) mit einer Dotierstoffkonzentration von mindestens 10¹⁹cm⁻³ und eine GaAs-Verbindung umfassend oder aus einer GaAs Verbindung bestehend,
- eine dielektrische Schicht (20),
- einen mit der Unterseite (22) der IGBT Halbleiterstruktur (10) elektrisch leitend verbundenen ersten Anschlusskontakt (14) umfassend ein Metall oder eine Metallverbindung oder bestehend aus einem Metall oder einer Metallverbindung,
- einen zweiten Anschlusskontakt (16) und einen dritten Anschlusskontakt (18) jeweils umfassend ein Metall oder eine Metallverbindung oder bestehend aus einem Metall oder einer Metallverbindung,
wobei
- der mindestens eine p-Bereich (32) mit der n⁻-Schicht (28) einen ersten pn-Übergang (36) ausbildet,
- der mindestens eine n⁺-Bereich (34) mit dem mindestens einen p-Bereich (32) einen zweiten pn-Übergang (38) ausbildet,
- die dielektrische Schicht (20) zumindest den ersten pn-Übergang (36) und den zweiten pn-Übergang (38) überdeckt und mit der n⁻-Schicht (28), dem p-Bereich (32) und dem n⁺-Bereich (34) stoffschlüssig verbunden ist,
- der zweite Anschlusskontakt (16) als Feldplatte auf der dielektrischen Schicht (20) ausgebildet ist und
- der dritte Anschlusskontakt (18) mit dem mindestens einen p-Bereich (32) und dem mindestens einen n⁺-Bereich (34) elektrisch leitend verbunden ist,
wobei zwischen dem p⁺-Substrat (24) und der n⁻-Schicht (28) eine dotierte Zwischenschicht (26) mit einer Schichtdicke (D3) von 1 µm -50 µm und einer Dotierstoffkonzentration von 10¹²-10¹⁷ cm⁻³ angeordnet ist, wobei die Zwischenschicht (26) zumindest mit dem p⁺-Substrat (24) stoffschlüssig verbunden ist.

2. IGBT Halbleiterstruktur (10) nach Anspruch 1, **dadurch gekennzeichnet, dass** die Zwischenschicht (26) p-dotiert ausgebildet ist.

3. IGBT Halbleiterstruktur (10) nach Anspruch 2, **dadurch gekennzeichnet, dass** die Dotierstoffkonzentration der Zwischenschicht (26) kleiner als die Dotierstoffkonzentration des p⁺-Substrats (24) ausgebildet oder die Dotierstoffkonzentration der Zwischenschicht (26) in einem Bereich zwischen einem Faktor 2 bis zu einem Faktor von fünf Größenordnungen kleiner als die Dotierstoffkonzentration des p⁺-Substrats (24) ist.

4. IGBT Halbleiterstruktur (10) nach Anspruch 2 oder 3, **dadurch gekennzeichnet, dass** die Zwischenschicht (26) Zink und/oder Silizium umfasst.

5. IGBT Halbleiterstruktur (10) nach Anspruch 1, **dadurch gekennzeichnet, dass** die Zwischenschicht (26) n-dotiert ausgebildet ist.

6. IGBT Halbleiterstruktur (10) nach Anspruch 5, **dadurch gekennzeichnet, dass** die Zwischenschicht (26) Silizium und / oder Zinn umfasst.

7. IGBT Halbleiterstruktur (10) nach Anspruch 5 oder 6, **dadurch gekennzeichnet, dass** die Dotierstoffkonzentration der Zwischenschicht (26) um bis zu einem Faktor 100 kleiner als die Dotierstoffkonzentration der n⁻-Schicht (28) ist.

8. IGBT Halbleiterstruktur (10) nach einem der Ansprüche 1 bis 7, **dadurch gekennzeichnet, dass** die IGBT Halbleiterstruktur (10) eine n-dotierte Pufferschicht (40) aufweist, wobei die Pufferschicht (40) zwischen der Zwischenschicht (26) und der n⁻-Schicht (28) angeordnet ist, eine Dotierstoffkonzentration von 10¹²-10¹⁷ cm⁻³ und eine Schichtdicke (D4) von 1 µm - 50 µm aufweist und eine GaAs-Verbindung umfasst oder aus einer GaAs Verbindung besteht.

9. IGBT Halbleiterstruktur (10) nach einem der Ansprüche 1 bis 8, **dadurch gekennzeichnet, dass** die IGBT Halbleiterstruktur (10) als Trench IGBT Halbleiterstruktur (10) ausgebildet ist, wobei die dielektrische Schicht (20) senkrecht zu der Oberseite (12) der IGBT Halbleiterstruktur (10) verläuft.

10. IGBT Halbleiterstruktur (10) nach einem der Ansprüche 1 bis 9, **dadurch gekennzeichnet, dass** das p⁺-Substrat (24) Zink umfasst.

11. IGBT Halbleiterstruktur (10) nach einem der Ansprüche 1 bis 10, **dadurch gekennzeichnet, dass** die n⁻-Schicht (28) und/oder der n⁺-Bereich (34) Silizium und/oder Chrom und/oder Palladium und/oder Zinn umfassen.

12. IGBT Halbleiterstruktur (10) nach einem der Ansprüche 1 bis 11, **dadurch gekennzeichnet, dass** die IGBT Halbleiterstruktur (10) monolithisch ausgebildet ist.

13. IGBT Halbleiterstruktur (10) Halbleiterstruktur nach einem der Ansprüche 1 bis 12, **dadurch gekennzeichnet, dass** eine Gesamthöhe (H1) der IGBT Halbleiterstruktur (10) höchstens 150-500 µm beträgt.

14. IGBT Halbleiterstruktur (10) nach einem der Ansprüche 1 bis 13, **dadurch gekennzeichnet, dass** der p-Bereich (32) und/oder der n⁺-Bereich (34) an der Oberseite (12) der IGBT Halbleiterstruktur (10) oval oder kreisförmig ausgebildet sind.

15. IGBT Halbleiterstruktur (10) nach einem der Ansprüche 1 bis 14, **dadurch gekennzeichnet, dass** die IGBT Halbleiterstruktur (10) Kantenlängen (K1, K2) oder einen Durchmesser (A1) von 1mm bis 15mm aufweist.

16. IGBT Halbleiterstruktur (10) nach einem der Ansprüche 1 bis 15, **dadurch gekennzeichnet, dass** die dielektrische Schicht (20) ein abgeschiedenes Oxid umfasst und eine Schichtdicke (D5) von 10 nm bis 1 µm aufweist.

## Claims

1. IGBT semiconductor structure (10) with an upper side (122) and a lower side (22) comprising
- a p⁺ substrate (24), which is formed at the lower side (22) of the IGBT semiconductor structure (10), with a doping substance concentration of 5^{∗}10¹⁸ - 5^{∗}10²⁰ cm⁻³, a layer thickness (D1) of 50 - 500 µm and comprising a GaAs compound or consisting of a GaAs compound,
- an n⁻ layer (28) with a doping substance concentration of 10¹² - 10¹⁷ cm⁻³, a layer thickness (D2) of 10 - 300 µm and comprising a GaAs compound or consisting of a GaAs compound,
- at least one p region (32), which adjoins the n⁻ layer (28), with a doping substance concentration of 10¹⁴n - 10¹⁸ cm⁻³ and comprising a GaAs compound or consisting of a GaAs compound,
- at least one n⁺ region (34), which adjoins the p region (32), with a doping substance concentration of at least 10¹⁹ cm⁻³ and comprising a GaAs compound or consisting of a GaAs compound,
- a dielectric layer (20),
- a first connecting contact (14) which is electrically conductively connected with the lower side (22) of the IGBT semiconductor structure (10) and which comprises a metal or a metal compound or consists of a metal or a metal compound,
- a second connecting contact (16) and a third connecting contact (18) each comprising a metal or a metal compound or consisting of a metal or a metal compound,
wherein
- the at least one p region (32) forms, together with the n⁻ layer (28), a first pn transition (36),
- the at least one n⁺ region (34) forms, together with the at least one p region (32), a second pn transition (38),
- the dielectric layer (20) covers at least the first pn transition (36) and the second pn transition (38) and is connected with the n⁻ layer (28), the p region (32) and the n⁺ region (34) by material couple,
- the second connecting contact (16) is constructed as a field plate on the dielectric layer (20) and
- the third connecting contact (18) is electrically conductively connected with the at least one p region (32) and the at least n⁺ region (34),
wherein
a doped intermediate layer (26) with a layer thickness (D3) of 1 µm - 50 µm and a doping substance concentration of 10¹² - 10¹⁷ cm⁻³ is arranged between the p⁺ substrate (24) and the n⁻ layer (28), wherein the intermediate layer (26) is connected at least with the p⁺ substrate (24) by material couple.

2. IGBT semiconductor structure (10) according to claim 1, **characterised in that** the intermediate layer (26) is constructed to be p-doped.

3. IGBT semiconductor structure (10) according to claim 2, **characterised in that** the doping substance concentration of the intermediate layer (26) is formed to be less than the doping substance concentration of the p⁺ substrate (24) or the doping substance concentration of the intermediate layer (26) is less than the doping substance concentration of the p⁺ substrate (24) in a range between a factor 2 up to a factor of five orders of magnitude.

4. IGBT semiconductor structure (10) according to claim 2 or 3, **characterised in that** the intermediate layer (26) comprises zinc and/or silicon.

5. IGBT semiconductor structure (10) according to claim 1, **characterised in that** the intermediate layer (26) is formed to be n-doped.

6. IGBT semiconductor structure (10) according to claim 5, **characterised in that** the intermediate layer (26) comprises silicon and/or tin.

7. IGBT semiconductor structure (10) according to claim 5 or 6, **characterised in that** the doping substance concentration of the intermediate layer (26) is less than the doping substance concentration of the n⁻ layer (28) by up to a factor 100.

8. IGBT semiconductor structure (10) according to any one of claims 1 to 7, **characterised in that** the IGBT semiconductor structure (10) comprises an n-doped buffer layer (40), wherein the buffer layer (40) is arranged between the intermediate layer (26) and the n⁻ layer (28), has a doping substance concentration of 10¹² - 10¹⁷ cm⁻³ and a layer thickness (D4) of 1µm - 50 µm and comprises a GaAs compound or consists of a GaAs compound.

9. IGBT semiconductor structure (10) according to any one of claims 1 to 8, **characterised in that** the IGBT semiconductor structure (10) is constructed as a trench IGBT semiconductor structure (10), wherein the dielectric layer (10) extends perpendicularly to the upper side (12) of the IGBT semiconductor structure (10).

10. IGBT semiconductor structure (10) according to any one of claims 1 to 9, **characterised in that** the p⁺ substrate (24) comprises zinc.

11. IGBT semiconductor structure (10) according to any one of claims 1 to 10, **characterised in that** the n⁻ layer (28) and/or the n⁺ region (34) comprises or comprise silicon and/or chromium and/or palladium and/or tin.

12. IGBT semiconductor structure (10) according to any one of claims 1 to 11, **characterised in that** the IGBT semiconductor structure (10) is of monolithic construction.

13. IGBT semiconductor structure (10) according to any one of claims 1 to 12, **characterised in that** an overall height (H1) of the IGBT semiconductor structure (10) is at most 150 - 500 µm.

14. IGBT semiconductor structure (10) according to any one of claims 1 to 13, **characterised in that** the p region (32) and/or the n⁺ region (34) is or are formed at the upper side (12) of the IGBT semiconductor structure (10) to be oval or circular.

15. IGBT semiconductor structure (10) according to any one of claims 1 to 14, **characterised in that** the IGBT semiconductor structure (10) has edge lengths (K1, K2) or a diameter (A1) of 1 mm to 15 mm.

16. IGBT semiconductor structure (10) according to any one of claims 1 to 15, **characterised in that** the dielectric layer (20) comprises a deposited oxide and has a layer thickness (D5) of 10 nm to 1 µm.

## Revendications

1. Structure semi-conductrice IGBT (10) présentant un côté supérieur (12) et un côté inférieur (22), comprenant :
un substrat p⁺ (24) formé sur le côté inférieur (22) de la structure semi-conductrice IGBT (10) qui présente une concentration de substances dopantes comprise entre 5^{∗}10¹⁸ cm⁻³ et 5^{∗}10²⁰ cm⁻³, une épaisseur de couche (D1) comprise entre 50 µm et 500 µm, et qui comprend un composé GaAs ou qui se compose d'un composé GaAs,
une couche n⁻ (28) qui présente une concentration de substances dopantes comprise entre 10¹² cm⁻³ et 10¹⁷ cm⁻³, une épaisseur de couche (D2) comprise entre 10 µm et 300 µm, et qui comprend un composé GaAs ou qui se compose d'un composé GaAs,
au moins une zone p (32) adjacente à la couche n⁻ (28) qui présente une concentration de substances dopantes comprise entre 10¹⁴ cm⁻³ et 10¹⁸ cm⁻³ et qui comprend un composé GaAs ou qui se compose d'un composé GaAs,
au moins une zone n⁺ (34) adjacente à la zone p (32) qui présente une concentration de substances dopantes d'au moins 10¹⁹ cm⁻³ et qui comprend un composé GaAs ou qui se compose d'un composé GaAs,
une couche diélectrique (20),
un premier contact de raccordement (14) relié de façon électriquement conductrice au côté inférieur (22) de la structure semi-conductrice IGBT (10) qui comprend un métal ou un composé métallique ou qui se compose d'un métal ou d'un composé métallique,
un deuxième contact de raccordement (16) et un troisième contact de raccordement (18) qui comprennent respectivement un métal ou un composé métallique ou qui se composent respectivement d'un métal ou d'un composé métallique,
dans laquelle
ladite au moins une zone p (32) forme avec la couche n⁻ (28) une première jonction pn (36),
ladite au moins une zone n⁺ (34) forme avec ladite au moins une zone p (32) une deuxième jonction pn (38),
la couche diélectrique (20) recouvre la première jonction pn (36) et la deuxième jonction pn (38) et est matériellement assemblée à la couche n⁻ (28), à la zone p (32) et à la zone n⁺ (34),
le deuxième contact de raccordement (16) est réalisé sous la forme d'une plaque de champ sur la couche diélectrique (20) et
le troisième contact de raccordement (18) est relié de façon électriquement conductrice à ladite au moins une zone p (32) et à ladite au moins une zone n⁺ (34), dans laquelle
une couche intermédiaire dopée (26) qui présente une épaisseur de couche (D3) comprise entre 1 µm et 50 µm et une concentration de substances dopantes comprise entre 10¹² cm⁻³ et 10¹⁷ cm⁻³ est disposée entre le substrat p⁺ (24) et la couche n⁻ (28), la couche intermédiaire (26) étant matériellement assemblée au moins au substrat p⁺ (24).

2. Structure semi-conductrice IGBT (10) selon la revendication 1, **caractérisée en ce que** la couche intermédiaire (26) est réalisée avec un dopage p.

3. Structure semi-conductrice IGBT (10) selon la revendication 2, **caractérisée en ce que** la concentration de substances dopantes de la couche intermédiaire (26) est fixée à un niveau inférieur à la concentration de substances dopantes du substrat p⁺ (24) ou la concentration de substances dopantes de la couche intermédiaire (26) est inférieure d'un facteur situé dans une plage comprise entre un facteur de deux ordres de grandeur jusqu'à un facteur de cinq ordres de grandeur à la concentration de substances dopantes du substrat p⁺ (24).

4. Structure semi-conductrice IGBT (10) selon la revendication 2 ou 3, **caractérisée en ce que** la couche intermédiaire (26) comprend du zinc et/ou du silicium.

5. Structure semi-conductrice IGBT (10) selon la revendication 1, **caractérisée en ce que** la couche intermédiaire (26) est réalisée avec un dopage n⁻.

6. Structure semi-conductrice IGBT (10) selon la revendication 5, **caractérisée en ce que** la couche intermédiaire (26) comprend du silicium et/ou de l'étain.

7. Structure semi-conductrice IGBT (10) selon la revendication, 5 ou 6, **caractérisée en ce que** la concentration de substances dopantes de la couche intermédiaire (26) est inférieure jusqu'à un facteur 100 à la concentration de substances dopantes de la couche n⁻ (28).

8. Structure semi-conductrice IGBT (10) selon l'une quelconque des revendications 1 à 7, **caractérisée en ce que** la structure semi-conductrice IGBT (10) présente une couche tampon à dopage n (40), dans laquelle la couche tampon (40) est disposée entre la couche intermédiaire (26) et la couche n⁻ (28), présente une concentration de substances dopantes comprise entre 10¹² cm⁻³ et 10¹⁷ cm⁻³ et une épaisseur de couche (D4) comprise entre 1 µm et 50 µm, et comprend un composé GaAs ou se compose d'un composé GaAs.

9. Structure semi-conductrice IGBT (10) selon l'une quelconque des revendications 1 à 8, **caractérisée en ce que** la structure semi-conductrice IGBT (10) est réalisée sous la forme d'une structure semi-conductrice IGBT Trench (10), dans laquelle la couche diélectrique (20) s'étend perpendiculairement au côté supérieur (12) de la structure semi-conductrice IGBT (10).

10. Structure semi-conductrice IGBT (10) selon l'une quelconque des revendications 1 à 9, **caractérisée en ce que** le substrat p⁺ (24) comprend du zinc.

11. Structure semi-conductrice IGBT (10) selon l'une quelconque des revendications 1 à 10, **caractérisée en ce que** la couche n⁻ (28) et/ou la zone n⁺ (34) comprend(-nent) du silicium et/ou du chrome et/ou du palladium et/ou de l'étain.

12. Structure semi-conductrice IGBT (10) selon l'une quelconque des revendications 1 à 11, **caractérisée en ce que** la structure semi-conductrice IGBT (10) est réalisée sous forme monolithique.

13. Structure semi-conductrice IGBT (10) en structure semi-conductrice selon l'une quelconque des revendications 1 à 12, **caractérisée en ce qu'**une hauteur totale (H1) de la structure semi-conductrice IGBT (10) est au maximum comprise entre 150 µm et 500 µm.

14. Structure semi-conductrice IGBT (10) selon l'une quelconque des revendications 1 à 13, **caractérisée en ce que** la zone p (32) et/ou la zone n⁺ (34) est (sont) réalisée(s) sous forme ovale ou circulaire sur le côté supérieur (12) de la structure semi-conductrice IGBT (10).

15. Structure semi-conductrice IGBT (10) selon l'une quelconque des revendications 1 à 14, **caractérisée en ce que** la structure semi-conductrice IGBT (10) présente des longueurs de côté (K1, K2) ou un diamètre (A1) compris entre 1 mm et 15 mm.

16. Structure semi-conductrice IGBT (10) selon l'une quelconque des revendications 1 à 15, **caractérisée en ce que** la couche diélectrique (20) comprend un oxyde déposé et présente une épaisseur de couche (D5) comprise entre 10 nm et 1 µm.
